Europäisches Patentamt

European Patent Office

Office européen des brevets

(19)

(11) **EP 0 544 589 B1**

(12) **FASCICULE DE BREVET EUROPEEN**

(45) Date de publication et mention
de la délivrance du brevet:
**10.09.1997   Bulletin 1997/37**

(51) Int Cl.⁶: **G01R 19/22**, G01R 19/04

(21) Numéro de dépôt: **92403169.3**

(22) Date de dépôt: **25.11.1992**

(54) **Dispositif de mesure du taux de charge réel d'un générateur électrique**

Gerät zur Messung des realen Lastfaktors eines elektrischen Generators

Device for measuring the real load rate of an electrical generator

(84) Etats contractants désignés:
**DE ES FR GB IT NL**

(30) Priorité: **26.11.1991   FR 9114558**

(43) Date de publication de la demande:
**02.06.1993   Bulletin 1993/22**

(73) Titulaire: **ALCATEL ALSTHOM COMPAGNIE GENERALE D'ELECTRICITE**
**75008 Paris (FR)**

(72) Inventeurs:
• **Oudille, Jean-Claude**
**F-37300 Joue Les Tours (FR)**

• **Veiga, Antonio**
**F-37000 Tours (FR)**

(74) Mandataire: **Sciaux, Edmond et al**
**ALCATEL ALSTHOM,**
**Département de Propriété Industrielle,**
**30, avenue Kléber**
**75116 Paris (FR)**

(56) Documents cités:
  **DE-A- 1 588 373**      **DE-A- 1 638 488**
  **DE-A- 3 728 163**      **US-A- 4 884 019**

• **RADIO FERNSEHEN ELEKTRONIK, vol. 35, no. 11, 1986, page 735, Berlin, DE; W. MICHEL: "Digitaler Spitzenwertmesser"**

## Description

La présente invention se rapporte à un dispositif de mesure du taux de charge réel d'un générateur électrique débitant un courant alternatif dans un appareil consommateur.

Le taux de charge d'un générateur de courant alternatif est habituellement évalué en mesurant la valeur efficace de la puissance ou de l'intensité du courant qui lui est demandé par l'appareil utilisateur, et en comparant le résultat de cette mesure à la valeur maximale de la grandeur correspondante telle qu'elle est spécifiée dans les caractéristiques nominales du générateur.

Si ce mode de mesure convient lorsque le générateur débite dans une charge purement résistive, il n'en va pas de même dans le cas où il s'agit d'une charge dite "déformante", c'est-à-dire de caractéristique non linéaire (par exemple une charge comportant un étage d'entrée constitué par un pont redresseur débitant sur un condensateur de filtrage). Dans un tel cas, la valeur de crête de l'intensité du courant est notablement supérieure à celle qu'elle serait pour une charge équivalente non déformante, cette dernière étant égale à la valeur efficace multipliée par $\sqrt{2}$, tandis que l'intensité de crête peut être de 2 à 5 fois plus grande que la valeur efficace si la charge est déformante. La comparaison des valeurs efficaces conduit alors à des conclusions erronées qui font largement sous-estimer le taux de charge réel du générateur.

Cette erreur systématique, que ne permettent pas de déceler les appareils de mesure classiques dont peuvent être pourvus le générateur et l'appareil utilisateur qui le charge, présente de graves inconvénients. Non seulement le taux de charge réel du générateur est inconnue, mais encore le dépassement éventuel, à certains instants, de la limite intrinsèque que comporte le générateur affecte la fiabilité de l'ensemble et conduit à des comportements intempestifs de celui-ci, tels qu'entrée en limitation, disjonction ou basculement sur une source de secours.

Le document DE-A-1 588 373 décrit un dispositif de mesure du taux de charge réel d'un générateur électrique débitant un courant alternatif dans un appareil consommateur, comprenant:

- un capteur de courant délivrant un signal constamment proportionnel à l'intensité du courant débité par le générateur,
- un circuit redresseur recevant ledit signal et délivrant un signal redressé
- et des moyens d'étalonnage.

La présente invention a pour but de remédier à ces inconvénients et de permettre la mesure du taux de charge réel d'un générateur, défini comme étant égal au rapport entre la valeur de crête du courant débité et la valeur limite spécifiée parmi les caractéristiques nominales du générateur.

A cet effet, l'invention a pour objet un dispositif de mesure comprenant :

- un capteur de courant délivrant un signal constamment proportionnel à l'intensité du courant débité par le générateur,
- un circuit redresseur recevant ledit signal et délivrant un signal redressé,
- et des moyens d'étalonnage;

et est caractérisé par le fait qu'il comprend:

- un circuit détecteur de crête recevant le signal redressé et en extrayant la valeur de crête indiquée sur un indicateur
- et le fait que les moyens d'étalonnage permettent de régler le dispositif de mesure de façon que l'indicateur de valeur de crête affiche 100% lorsque la valeur de crête du courant alternatif mesuré atteint le niveau maximal prescrit.

Un tel dispositif, effectuant une mesure de crête, fournit une indication continuelle de la valeur maximale instantanée de l'intensité parcourant le capteur de courant, quelle que soit la forme, plus ou moins éloignée d'une sinusoïde, des évolutions du courant en fonction du temps. C'est cette valeur de crête, que doit réellement supporter le générateur, qui est présentée par l'indicateur sous forme d'un pourcentage entre la charge réelle et la charge maximale du générateur, indépendamment du degré de la déformation du courant infligée par l'appareil utilisateur chargeant le générateur.

En pratique, le capteur de courant peut être constitué soit par un shunt destiné à être parcouru par le courant à mesurer, soit par un transformateur d'intensité fermé sur un shunt; cette dernière solution présente l'avantage d'assurer un isolement galvanique entre l'appareil de mesure et le générateur.

Quant au circuit redresseur, il convient de le choisir du type dit "sans seuil" de façon à éliminer l'erreur systématique qu'introduirait un redresseur ordinaire affecté d'un seuil au voisinage du niveau zéro. Par ailleurs, il est préférable que le redresseur soit conçu pour assurer un redressement à double alternance. Dans une forme de réalisation avantageuse, le circuit redresseur comprend un redresseur mono-alternance suivi d'un sommateur ajoutant au signal de sortie de celui-ci la moitié de son signal d'entrée.

Le circuit détecteur de crête peut, pour sa part, comprendre un amplificateur comparateur dont la sortie est reliée, via une diode, à un condensateur en parallèle avec lequel est connectée une résistance, et dont une entrée reçoit le signal issu du redresseur, son autre entrée étant reliée, via un amplificateur de gain unité, audit condensateur.

L'usage d'un appareil de mesuré tel que défini ci-dessus en relation avec un générateur délivrant de l'énergie électrique permet d'effectuer une mesure correcte du taux de charge réel de celui-ci, de vérifier et éventuellement de corriger son dimensionnement énergétique nominal, d'accroître sa fiabilité et de faciliter son exploitation.

D'autre particularités et avantages de l'invention ressortiront de la description qui va suivre, en regard des dessins annexés, d'un exemple de réalisation non limitatif.

La figure 1 illustre un exemple d'évolution en fonction du temps de l'intensité demandée par un appareil utilisateur "déformant".

La figure 2 représente la structure générale d'un dispositif de mesure selon l'invention.

La figure 3 représente le schéma détaillé du dispositif de mesure de la figure 2.

La figure 4 représente les formes d'onde qui peuvent être observées en divers points du circuit schématisé à la figure 3.

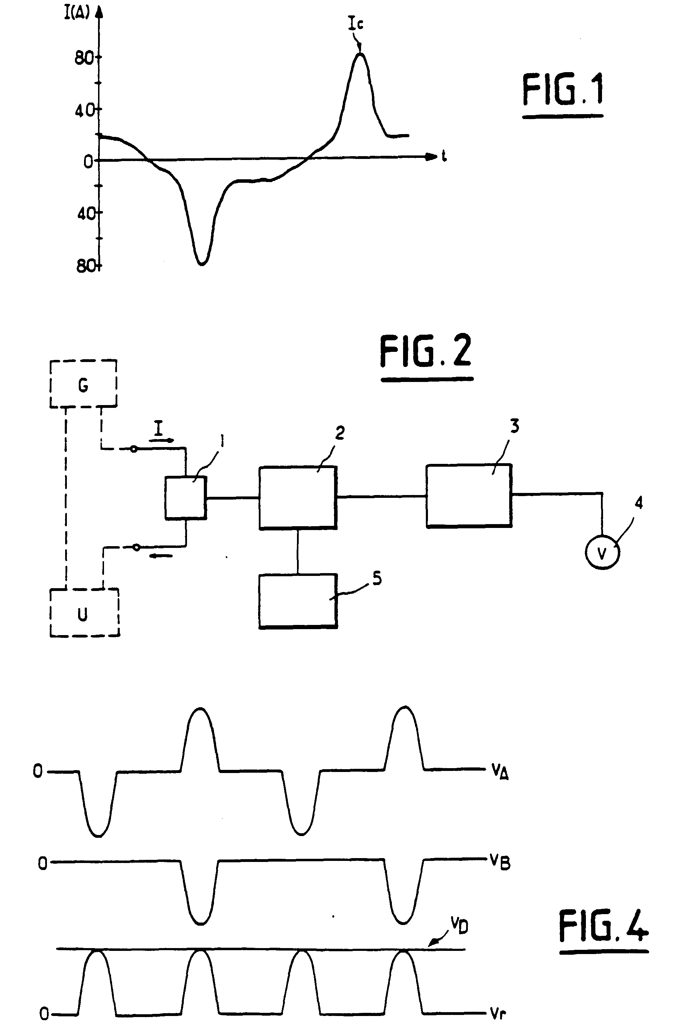

On voit sur la figure 1 comment peut évoluer en fonction du temps le courant débité par un générateur électrique de courant alternatif, tel qu'un ensemble onduleur (composé de plusieurs modules), sur une charge déformante. Alors qu'un ampèremètre classique traversé par ce courant indique une intensité de 35 A, la valeur de crête Ic est beaucoup plus élevée, atteignant 80 A, et peut dépasser, à l'insu de l'utilisateur, la valeur limite de l'intensité de crête que peut débiter l'onduleur. Une telle situation anormale, qui conduit à des troubles de fonctionnement, peut être décelée par la mesure de la valeur de crête du courant effective et la comparaison de celle-ci à la valeur limite attachée au générateur.

Cette mesure peut être réalisée à l'aide d'un dispositif dont la structure générale est montrée à la figure 2. Le dispositif de mesure, destiné à être connecté en série entre un générateur G et un appareil utilisateur U, comprend un capteur d'intensité 1 qui, traversé par le courant I dont la valeur de crête doit être déterminée, délivre un signal alternatif dont la tension est à chaque instant proportionnelle à l'intensité dudit courant. Dans le cas de l'exemple précédent, la tension de ce signal évolue de la même façon que l'intensité du courant dont les variations sont représentées à la figure 1. Le signal alternatif délivré par le capteur 1 est appliqué à un redresseur à double alternance 2 qui délivre un signal redressé formé d'alternances de même polarité dont l'amplitude correspond à celle des alternances positives et négatives du signal de sortie du capteur 1. Le signal redressé est reçu par un détecteur de crête 3 qui fournit à sa sortie un signal continu dont l'amplitude, correspondant à la valeur de crête du signal redressé, est affichée par un indicateur 4 tel qu'un voltmètre. En outre, des moyens d'étalonnage 5 sont prévus, qui permettent de régler le dispositif de façon que l'indicateur affiche 100 % lorsque la valeur de crête du courant I atteint la valeur limite du courant instantané que peut fournir le générateur utilisé dans chaque cas particulier.

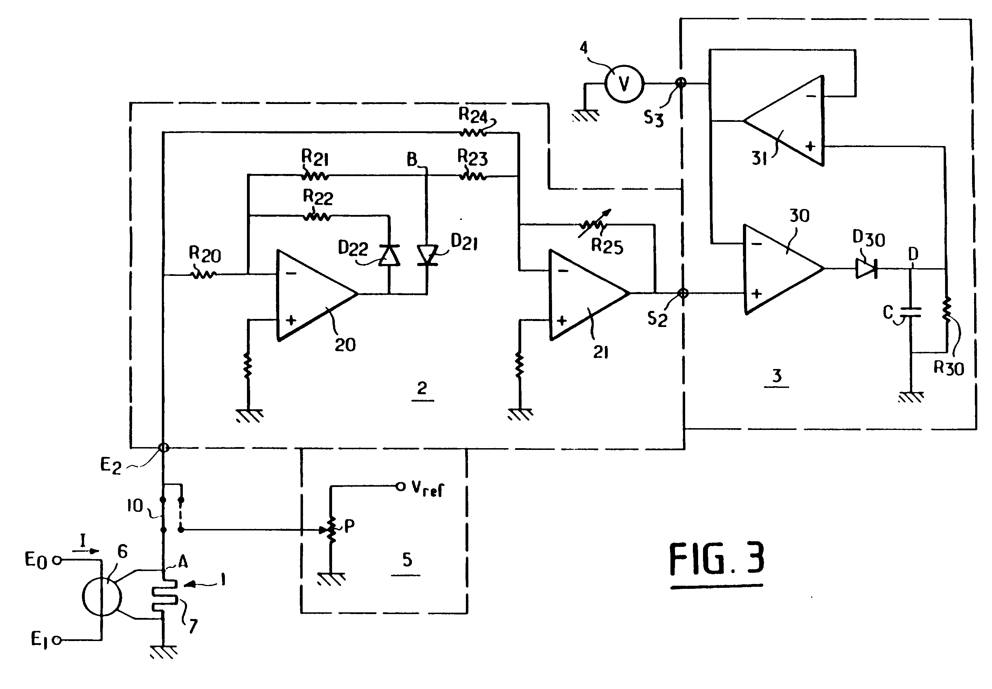

Conformément à la figure 3, le capteur 1 comprend un transformateur d'intensité 6 abaisseur de courant, dont le primaire est relié à des bornes d'entrées $E_o$, $E_1$ permettant son insertion dans le circuit de puissance du générateur électrique et dont le secondaire est relié à un shunt 7, c'est-à-dire à une résistance de faible valeur, aux bornes de laquelle se développe un signal de tension $V_A$ représentatif de l'intensité I circulant dans le primaire. Ce signal $V_A$ est disponible sur la borne A du shunt 7, dont l'autre borne est mise à la masse du dispositif. En variante, le transformateur 6 peut être supprimé, le courant I étant directement injecté dans le shunt 7, qui alors délivre de même le signal $V_A$ précité. Toutefois, l'isolement fourni par le transformateur 6 entre le circuit de puissance et le dispositif de mesure disparaît, ce qui constitue éventuellement un inconvénient.

La borne A du shunt 7 est reliée, via un commutateur 10, à la borne d'entrée $E_2$ du redresseur à double alternance 2. Celui-ci est de type dit sans seuil, c'est-à-dire que le seuil au-delà duquel il commence à fournir une tension de sortie lorsque la tension d'entrée franchit le niveau zéro est de valeur nulle. Il comprend deux amplificateurs opérationnels 20, 21. L'entrée inverseuse du premier amplificateur 20 est reliée à l'entrée $E_2$ via une résistance $R_{20}$ et à sa sortie via une résistance $R_{21}$ en série avec une diode $D_{21}$ et via une résistance $R_{22}$ en série avec une diode $D_{22}$. Ces deux diodes sont disposées en sens inverse, la diode $D_{21}$ étant reliée par sa cathode à la sortie S et la diode $D_{22}$ par son anode. L'entrée inverseuse du deuxième amplificateur 21 est reliée par une résistance $R_{23}$ au point B commun à la résistance $R_{21}$ et la diode $D_{21}$ et, par une résistance $R_{24}$, à l'entrée $E_2$ du redresseur 2. L'amplificateur 21 est par ailleurs bouclé par une résistance variable $R_{25}$ connectée entre son entrée inverseuse et sa sortie, laquelle constitue la sortie $S_2$ du redresseur 2. Les résistances précitées sont choisies telles que leurs valeurs vérifient les relations suivantes :

$$R_{20} = R_{21} = R_{22} = R_{23} = R_{24}/2$$

Le détecteur de crête 3 comprend un premier amplificateur opérationnel 30 dont l'entrée non inverseuse est reliée à la sortie $S_2$ du redresseur 2 et dont la sortie est reliée à l'anode d'une diode $D_{30}$ dont la cathode est connectée à une borne d'un condensateur C dont l'autre borne est reliée à la masse. En parallèle avec ce condensateur est connectée une résistance $R_{30}$. Le point D commun à la diode $D_{30}$, au condensateur C et à la résistance $R_{30}$ est relié à l'entrée non inverseuse du deuxième amplificateur 31 bouclé en gain unité, dont la sortie $S_3$ est reliée à l'entrée inverseuse du premier amplificateur 30, ainsi qu'à un voltmètre 4 affichant la tension présente à la sortie de l'amplificateur 31.

Lorsqu'un courant alternatif, aussi bien sinusoïdal que déformé, est appliqué au transformateur 6 via ses entrées $E_o$, $E_1$, un signal de tension $V_A$ de forme semblable (figure 4) apparaît au point A, composé d'alternances positives et négatives, qui est transmis à l'entrée

$E_2$ du redresseur 2. En présence des alternances positives, la diode $D_{21}$ associée à l'amplificateur 20 conduit et la diode $D_{22}$ est bloquée. Dès lors, le gain de celui-ci, compté entre les points $E_2$ et B, est égal à - 1 et lesdites alternances se retrouvent simplement inversées au point B. En présence des alternances négatives, la diode $D_{22}$ conduit et la diode $D_{21}$ est bloquée. Le point B se trouve donc isolé de la sortie S de l'amplificateur 20 et son potentiel est alors égal à celui de l'entrée inverseuse, c'est-à-dire zéro. Les alternances négatives ne se manifestent donc pas au point B. Finalement apparaît en ce point un signal $V_B$ tel que représenté à la figure 4. Du fait que la résistance $R_{23}$ reliée au point B est de valeur moitié de celle de la résistance $R_{24}$ reliée à l'entrée $E_2$, l'amplificateur 21 fournit à sa sortie un signal

$$Vr = -k(2V_B + V_A)$$

k étant une constante positive dépendant de la valeur donnée à la résistance variable $R_{25}$. Comme représenté à la figure 4, la forme de ce signal Vr est celle d'un signal ayant subi un redressement à double alternance.

Le signal redressé Vr est appliqué au détecteur de crête 3 où il assure la charge du condensateur C via l'amplificateur 30 et la diode $D_{30}$. La tension $V_D$ qui en résulte sur ce condensateur se retrouve identique, via l'amplificateur 31 offrant un gain + 1, sur l'entrée inverseuse de l'amplificateur 30. Par ailleurs, entre chaque période de charge du condensateur C sous l'effet des alternances du signal Vr, ce condensateur se décharge lentement dans la résistance $R_{30}$ (avec une constante de temps de l'ordre de quelques secondes). Dès lors, lorsque le signal Vr est supérieur au signal $V_D$, l'amplificateur fournit une tension de sortie positive qui charge le condensateur C via la diode $D_{30}$ rendue conductrice. Par contre, lorsque le signal Vr est inférieur au signal $V_D$, l'amplificateur 30 fournit à sa sortie une tension négative qui bloque la diode $D_{30}$, de sorte que le condensateur C continue à se décharger dans la résistance $R_{30}$, la tension du signal $V_D$ décroissant lentement jusqu'à ce qu'elle devienne inférieure à la tension de crête du signal Vr, auquel cas la charge du condensateur C reprend. Par le jeu de ces phénomènes de charge et de décharge qui résultent de la comparaison des niveaux respectifs des signaux Vr et $V_D$, la tension du signal $V_D$ aux bornes du condensateur C varie dans d'étroites limites autour de la valeur de crête du signal Vr, laquelle est proportionnelle à la valeur de crête, supposée variant lentement, du courant I injecté à l'entrée du dispositif. Par suite, le voltmètre 4, connecté à la sortie $S_3$ de l'amplificateur 31 et donnant ainsi la mesure de la tension du signal $V_D$, indique une valeur proportionnelle à la valeur de crête du courant I. Cette indication peut être fournie en pourcentage, la graduation 0 % correspondant à un courant I nul, donc à un taux de charge nul pour le générateur, et la graduation 100 % à un courant I dont les crêtes atteignent leur niveau maximal compatible avec les caractéristiques du générateur donc avec le taux de charge maximal de celui-ci.

Les moyens d'étalonnage 5 comprennent un potentiomètre P auquel est appliqué une tension de référence Vréf très stable engendrée par un circuit spécial non représenté. Grâce au commutateur 10, l'entrée $E_2$ du redresseur 2 peut être reliée soit au point A, pour une mesure d'intensité de crête, soit au curseur du potentiomètre P, pour un étalonnage. Dans ce dernier cas, on règle le potentiomètre P de façon que la tension au point $E_2$ soit égale à la tension de crête qui apparaîtrait au point A si le générateur électrique utilisé débitait l'intensité de crête maximale qu'il est capable de fournir. Puis on règle la résistance variable $R_{25}$ qui permet d'ajuster le gain de l'amplificateur 21 pour que le voltmètre affiche son indication maximale (100 %). On met alors le point $E_2$ en liaison avec le point A par actionnement du commutateur 10, et la mesure du taux de charge du générateur peut commencer.

## Revendications

1. Dispositif de mesure du taux de charge réel d'un générateur électrique débitant un courant alternatif dans un appareil consommateur, comprenant :

   - un capteur de courant (1) délivrant un signal ($V_A$) constamment proportionnel à l'intensité (I) du courant débité par le générateur,
   - un circuit redresseur (2) recevant ledit signal et délivrant un signal redressé (Vr),
   - et des moyens d'étalonnages (5) ;

   caractérisé par le fait qu'il comprend:

   - un circuit détecteur de crête (3) recevant le signal redressé et en extrayant la valeur de crête ($V_D$) indiquée sur un indicateur (4),
   - et le fait que les moyens d'étalonnage (5) permettent de régler le dispositif de mesure de façon que l'indicateur (4) de valeur de crête affiche 100% lorsque la valeur de crête du courant alternatif mesuré atteint le niveau maximal prescrit.

2. Dispositif selon la revendication 1, caractérisé par le fait que le capteur de courant (1) est constitué par un shunt destiné à être parcouru par le courant (I) mesurer.

3. Dispositif selon la revendication 1, caractérisé par le fait que le capteur de courant est constitué par un transformateur d'intensité (6) fermé sur un shunt (7).

4. Dispositif selon l'une quelconque des revendications 1 à 3, caractérisé par le fait que le circuit redresseur (2) est du type dit sans seuil.

5. Dispositif selon l'une quelconque des revendications 1 à 4, caractérisé par le fait que le redresseur assure un redressement à double alternance.

6. Dispositif selon la revendication 5, caractérisé par le fait que le circuit redresseur comprend un redresseur mono-alternance suivi d'un sommateur ajoutant au signal de sortie de celui-ci la moitié de son signal d'entrée.

7. Dispositif selon l'une quelconque des revendications 1 à 6, caractérisé par le fait que le circuit détecteur de crête (4) comprend un amplificateur comparateur (30) dont la sortie est reliée, via une diode ($D_{30}$), à un condensateur (C) en parallèle avec lequel est connectée une résistance ($R_{30}$), et dont une entrée reçoit le signal (Vr) issu du redresseur, son autre entrée étant reliée via un amplificateur (31) de gain unité, audit condensateur.

**Patentansprüche**

1. Vorrichtung zur Messung des tatsächlichen Lastfaktors eines elektrischen Wechselstromgenerators, der ein Verbrauchsgerät speist,

- mit einer Strommeßsonde (1), die ein zur Stärke des vom Generator abgegebenen Stroms (I) permanent proportionales Signal ($V_A$) liefert,
- mit einem Gleichrichterkreis (2), der dieses Signal empfängt und ein gleichgerichtetes Signal (Vr) liefert,
- und mit Eichmitteln (5),

dadurch gekennzeichnet,

- daß die Meßvorrichtung eine Spitzenwert-Detektorschaltung (3) aufweist, die das gleichgerichtete Signal empfängt und daraus den Spitzenwert ($V_D$) zur Anzeige in einem Anzeigeorgan (4) entnimmt,
- und daß die Eichmittel (5) eine Regelung der Meßvorrichtung so ermöglichen, daß das Anzeigeorgan (4) für den Spitzenwert 100% anzeigt, wenn der Spitzenwert des gemessenen Wechselstroms den vorgeschriebenen Maximalpegel erreicht.

2. Vorrichtung nach Anspruch 1, dadurch gekennzeichnet, daß die Strommeßsonde (1) von einem Widerstand gebildet wird, der von dem zu messenden Strom (I) durchflossen wird.

3. Vorrichtung nach Anspruch 1, dadurch gekennzeichnet, daß die Strommeßsonde von einem Stromtransformator (6) gebildet wird, der von einem Widerstand (7) abgeschlossen wird.

4. Vorrichtung nach einem beliebigen der Ansprüche 1 bis 3, dadurch gekennzeichnet, daß die Gleichrichterschaltung (2) keinen Schwellwert besitzt.

5. Vorrichtung nach einem beliebigen der Ansprüche 1 bis 4, dadurch gekennzeichnet, daß die Gleichrichterschaltung eine Zweiweg-Gleichrichtung bewirkt.

6. Vorrichtung nach Anspruch 5, dadurch gekennzeichnet, daB die Gleichrichterschaltung einen Einweg-Gleichrichter gefolgt von einem Summierglied enthält, das dem Ausgangssignal des Gleichrichters die Hälfte des Eingangssignals nochmals hinzufügt.

7. Vorrichtung nach einem beliebigen der Ansprüche 1 bis 6, dadurch gekennzeichnet, daß die Spitzenwert-Detektorschaltung (4) einen Komparatorverstärker (30) enthält, dessen Ausgang über eine Diode ($D_{30}$) an die Parallelschaltung eines Kondensators (C) und eines Widerstands ($R_{30}$) angeschlossen ist, und der an einem Eingang das Ausgangssignal (Vr) des Gleichrichters empfängt und mit seinem anderen Eingang über einen Einheitsverstärker (31) an den Kondensator angeschlossen ist.

**Claims**

1. Measuring apparatus for measuring the real load factor on an electricity source delivering an AC current to a consumer appliance, said apparatus comprising:

a current sensor (1) supplying a signal ($V_A$) that is continuously proportional to the current (I) delivered by the source;
a rectifier circuit (2) receiving said signal and supplying a rectified signal (Vr); and
calibration means (5);
said apparatus being characterized by the fact that it comprises a peak detector circuit (3) receiving the rectified signal and extracting therefrom the peak value ($V_D$) indicated on an indicator (4), and by the fact that the calibration means (5) enable the measuring apparatus to be set so that the peak value indicator (4) displays 100% when the measured peak value of the AC current reaches the specified maximum level.

2. Apparatus according to claim 1, characterized by the fact Lhat the current sensor (1) is constituted by a shunt resistor through which the current (I) to be measured passes.

3. Apparatus according to claim 1, characterized by the fact that the current sensor is constituted by a current transformer (6) looped through a shunt resistor (7).

4. Apparatus according to any one of claims 1 to 3, characterized by the fact that the rectifier circuit (2) is of the no threshold type.

5. Apparatus according to any one of claims 1 to 4, characterized by the fact that the rectifier provides full-wave rectification.

6. Apparatus according to claim 5, characterized by the fact that the rectifier circuit comprises a half-wave rectifier followed by a summing circuit adding half of its input signal to its output signal.

7. Apparatus according to any one of claims 1 to 6, characterized by the fact that the peak detector circuit (4) includes a comparator-amplifier (30) whose output is connected via a diode ($D_{30}$) to a capacitor (C) having a resistor ($R_{30}$) connected in parallel therewith, one input of the comparator-amplifier receiving the signal (Vr) from the rectifier, and its other input being connected to said capacitor via a unity-gain amplifier (31).

FIG.1

FIG.2

FIG.4

FIG. 3